# EUROPÄISCHE PATENTSCHRIFT

(11) **EP 0 856 201 B1**
(45) Veröffentlichungstag und Bekanntmachung des Hinweises auf die Patenterteilung: **12.02.2003**
(21) Anmeldenummer: 96945510.4
(22) Anmeldetag: 16.10.1996
(51) Int. Cl.: H01L 31/0352, H01L 31/105

(54) **HALBLEITERHETEROSTRUKTUR-STRAHLUNGSDETEKTOR, MIT ZWEI SPEKTRALEN EMPFINDLICHKEITSBEREICHEN**
SEMICONDUCTOR HETEROSTRUCTURE RADIATION DETECTOR, WITH TWO SPECTRAL SENSITIVITY REGIONS
DETECTEUR DE RAYONNEMENT A HETEROSTRUCTURE DE SEMI-CONDUCTEUR, POURVU DE DEUX ZONES DE SENSIBILITE SPECTRALES

(30) Priorität: 17.10.1995 DE 19538650
(43) Veröffentlichungstag der Anmeldung: 05.08.1998
(73) Patentinhaber: FRAUNHOFER-GESELLSCHAFT ZUR FÖRDERUNG DER ANGEWANDTEN FORSCHUNG E.V., 80636 München (DE)
(72) Erfinder: SCHNEIDER, Harald, D-79194 Gundelfingen (DE); SCHÖNBEIN, Clemens, D-79108 Freiburg (DE)
(74) Vertreter: Münich, Wilhelm, Dr.
(86) Internationale Anmeldenummer: DE9601983
(87) Internationale Veröffentlichungsnummer: WO97017719

(56) Entgegenhaltungen:
- US-A- 5 023 685
- APPLIED PHYSICS LETTERS, Bd. 56, Nr. 3, 15.Januar 1990, Seiten 227-229, XP000127387 TOKUDA Y ET AL: "DUAL-WAVELENGTH MULTIPLE QUANTUM WELL N-I-P-I-N PHOTODETECTOR USING AN OPTICALLY BISTABLE ABRUPT ABSORPTION EDGE"
- APPLIED PHYSICS LETTERS, Bd. 62, Nr. 26, 28.Juni 1993, Seiten 3504-3506, XP000382506 TSAI K L ET AL: "TWO-COLOR INFRARED PHOTODETECTOR USING GAAS/ALGAAS AND STRAINED INGAAS/ALGAAS MULTIQUANTUM WELLS" in der Anmeldung erwähnt
- PROCEEDINGS OF THE SPIE, Bd. 2274, 24.Juli 1994, Seiten 117-125, XP000646263 WILSON J A ET AL: "INTEGRATED TWO-COLOR DETECTION FOR ADVANCED FPA APPLICATIONS"
- IBM TECHNICAL DISCLOSURE BULLETIN, Bd. 32, Nr. 3B, August 1989, Seite 270/271 XP000029855 "TYPE II SUPERLATTICE INFRARED PHOTODETECTOR"
- APPLIED PHYSICS LETTERS, Bd. 68, Nr. 13, 25.März 1996, Seiten 1832-1834, XP000582387 SCHNEIDER H ET AL: "VOLTAGE-TUNABLE TWO-COLOR DETECTION BY INTERBAND AND INTERSUBBAND TRANSITIONS IN A P-I-N-I-N STRUCTURE"
- APPLIED PHYSICS LETTERS, Bd. 60, Nr. 16, 20.April 1992, Seiten 2011-2013, XP000277832 KOECK A ET AL: "DOUBLE WAVELENGTH SELECTIVE GAAS/ALGAAS INFRARED DETECTOR DEVICE" in der Anmeldung erwähnt
- APPLIED PHYSICS LETTERS, Bd. 61, Nr. 6, 10.August 1992, Seiten 666-668, XP000290126 KHENG K ET AL: "TWO-COLOR GAAS/(ALGA)AS QUANTUM WELL INFRARED DETECTOR WITH VOLTAGE-TUNABLE SPECTRAL SENSITIVITY AT 3-5 AND 8-12 UM" in der Anmeldung erwähnt

## Beschreibung

### Technisches Gebiet

Die Erfindung bezieht sich auf einen Halbleiterheterostruktur-Strahlungsdetektor, der zwei spektrale Empfindlichkeitsbereiche aufweist. Die zwei spektralen Empfindlichkeitsbereiche resultieren aus aneinandergrenzenden Halbleiterschichtbereichen, in denen Photonen mit jeweils unterschiedlichen Energien absorbierbar sind. Die Photonen regen in den Halbleiterschichtbereichen vorhandene Ladungsträger derart optisch an, so daß in Abhängigkeit einer äußeren elektrischen Spannung, die über Elektroden, die an der Halbleiterschichtstruktur vorgesehen sind, ein Photostrom generierbar ist.

### Stand der Technik

Auf dem Gebiet der Halbleiter-Strahlungsdetektoren sind zum einen Photodioden bekannt mit herkömmlichen p-i-n-Übergängen auch sogenannte Quantumwell-Intersubband-Photodetektoren (QWIP), deren spektrale Empfindlichkeitseigenschaften durch entsprechende Wahl von Materialschichtsystemen, Schichtdickenparameter sowie der Wahl von n-oder p-Dotierungen eingestellt werden können. Herkömmliche Photodioden weisen spektrale Empfindlichkeiten im sichtbaren bis in den nahen infraroten Spektralbereich auf. Je nach Materialwahl können sie jedoch auch Wellenlängen im µm-Bereich detektieren. Die sogenannten Quantumwell-Intersubband-Photodetektoren weisen an sich spektrale Empfindlichkeitsbereiche im längerwelligen Spektralbereich auf, vorzugsweise im Bereich zwischen 3 und 20 µm-Bereich, welche sich durch die Wahl der Material- und Schichtdikkenparameter einstellen lassen.

Neben der Leistungssteigerung und Optimierung einzelner Strahlungdetektoren werden Kombinationen aus Strahlungsdetektoren untersucht, mit denen es möglich ist elektromagnetische Strahlung mit verschiedenen Wellenlängen zu erfassen. Es sind sogenannte Zweifarbendetektoren bekannt, die beispielsweise in der Thermographie sowie für die optische Diskriminierung bestimmter Objekte innerhalb des von dem Strahlungsdetektor erfaßten Aufnahmefeldes verwendet werden.

Aus dem Dokument "Applied Physics Leiters" Band 56 Nr. 3 vom 15. Januar 1990 (Seiten 227 - 229) ist ein Photodetektor mit einer n-i-p-i-n Struktur bekannt, der für zwei Längenbereiche empfindlich ist und der zwei von einander getrennt angeordnete Multiple-Quantum-Well-Strukturen aufweist. Damit sind aus dieser Veröffentlichung Merkmale bekannt, von denen bei der Bildung des Oberbegriffs des Patentanspruchs 1 ausgegangen wurde. So ist daraus ein Halbleiterheterostruktur-Strahlungsdetektor bekannt, der zwei aneinandergrenzende, in unterschiedlichen spektralen Bereichen empfindliche Halbleiterschichtbereiche aufweist, in denen Photonen mit jeweils unterschiedlichen Energien absorbierbar sind, die in den Halbleiterschichtbereichen vorhandene Ladungsträger derart optisch anregen, so dass ein Photostrom in den jeweiligen Halbleiterschichtbereichen in Abhängigkeit einer über Elektroden, die an der Halbleiterheterostruktur vorgesehen sind, anliegenden äußeren elektrischen Spannung generierbar ist.

In dem Artikel von A. Köck et al.: "Double wavelength selective GaAs/AlGaAs infrared detector device", Appl. Phys. Lett. 60, 2011 (1992) wird die Kombination zweier QWIP-Halbleiterstrukturen mit unterschiedlichen Detektionswelienlängen vorgeschlagen. Das in diesem Artikel vorgestellte 2-stufige QWIP-System besteht aus jeweils alternierenden GaAs/AlGaAs-Schichtabfolgen.

Zur unterschiedlichen spektralen Empfindlichkeitseinstellung werden Quantumwell-Strukturen verwendet, die sich durch die Dimensionierung der für die Quantumwell-Struktur charakteristischen Barrierenhöhe bzw. Bandabstand sowie Topfbreite bzw. Schichtdicke unterscheiden. Die für die Detektion unterschiedlicher Wellenlängen konditionierten QWIP-Strukturen sind jedoch durch eine zusätzliche dotierte Kontaktschicht voneinander getrennt. Die auf diese Weise erreichbare physikalische Separierung hat zwar den Vorteil, daß beide QWIP-Strukturen getrennt voneinander auf ihre jeweilige Arbeitswellenlänge optimiert werden können, doch haftet dieser Anordnung der Nachteil an, daß durch die Separierung für die Spannungsversorgung wenigstens eine zusätzliche Elektrode mehr erforderlich ist.

Aus Rationalisierungsgründen hat man daher versucht, die in der vorstehend genannten Literaturstelle beschriebene Detektorstruktur mit nicht angeschlossener, zusätzlicher Elektrode zu betreiben (siehe hierzu den Beitrag von K. L. Tsai, et al. "Two-color infrared photodetector using GaAs/AlGaAs and strained InGaAs/AlGaAs multiquantum wells", Appl. Phys. Letter 62, 3704, (1993)). Beim Betrieb derartiger Detektorstrukturen hat sich herausgestellt, daß die relative Empfindlichkeit bezüglich der beiden Arbeitswellenlängen durch Anlegen einer geeigneten elektrischen Spannung abstimmbar ist. Jedoch besteht der Nachteil, daß sich die elektrisch in Serie geschalteten Einzeldetektoren gegenseitig in ihrer Arbeitsweise beeinflussen. Je nach Anlegen einer äußeren Spannung kann die Photoempfindlichkeit eines der beiden kombinierten Detektoren erhöht werden, wobei die Empfindlichkeit des anderen Detektors abgksenkt ist. Das gesamte Rauschverhalten der Detektorkombination wird insbesondere durch den jeweils nicht an der Photodetektion beteiligten Detektorteil mitbestimmt, so daß das mit dieser Detektorstruktur erzielbare Signal- zu Rauschverhältnis verhältnismäßig schlecht ist.

Ferner ist ein Zweifarbendetektor aus einem Beitrag von K. Kheng et al. "Two-color GaAs/(AlGa)As quantum well infrared detector with voltage-tunable spectral sensitivity at 3-5 and 8-12 µm", Appl. Phys. Letter 61, 666 (1992), bekannt, der auf einer einzigen QWIP-Struktur mit zwei möglichen Intersubband-Übergängen, bei einer Wellenlängen von 5µm und 10µm, beruht. Die Auswahl der Arbeitswellenlänge wird dadurch ermöglicht, daß der 5µm-Übergang ein photovoltaisches und der 10µm-Übergang ein photoleitendes Verhalten zeigt. Auch hier besteht der prinzipielle Nachteil, daß das Rauschverhalten auch bei kürzeren Arbeitswellenlängen durch das mit der längerwelligen Detektion assoziierte Rauschen bestimmt wird.

Schließlich sind elektrisch abstimmbare Zweifarbendetektoren bekannt, die durch die Kombination zweier gegeneinander geschalteter p-i-n-Photodioden gebildet sind (siehe hierzu den Beitrag von M.P. Reine et al. "Independently accessed back-to-back HgCdTe photodiodes: A new dual-band infrared detector", J. Electronic Mater. 24, 669 (1995).

### Darstellung der Erfindung

Der Erfindung liegt die Aufgabe zugrunde, einen Halbleiterheterostruktur-Strahlungsdetektor, der zwei aneinandergrenzende, in unterschiedlichen spektralen Bereichen empfindliche Halbleiterschichtbereichen aufweist, in denen Photonen mit jeweils unterschiedlichen Energien absorbierbar sind, die in den Halbleiterschichtbereichen vorhandene Ladungsträger derart optisch anregen, so daß ein Photostrom in den jeweiligen Halbleiterschichtbereichen in Abhängigkeit einer über Elektroden, die an der Halbleiterheterostruktur vorgesehen sind, anliegenden äußeren elektrischen Spannung generierbar ist, derart weiterzubilden, daß die spektralen Empfindlichkeitsbereiche bei der Halbleiterschichtstrukturen ohne nachhaltige Beeinflussung des Gesamt-Rauschverhaltens des Zweifarbendetektors getrennt voneinander einstellbar sind. Insbesondere soll das Rauschverhalten des Zweifarbendetektors durch das Rauschen des jeweils aktiven Einzeldetektors dominiert werden. Ferner sollen die spektralen Empfindlichkeitsbereiche beider Halbleiterschichtdetektoren weitgehend unabhängig voneinander eingestellt und optimiert werden können.
Die Lösung der der Erfindung zugrunde liegenden Aufgabe ist im Anspruch 1 angegeben. Den Erfindungsgedanken vorteilhaft ausgestaltende weitere Ausführungsformen sind in den Ansprüchen 2ff. angegeben.

Der Erfindung liegt die Erkenntnis zugrunde, einen Halbleiterheterostruktur-Strahlungsdetektor gemäß dem Oberbegriff des Anspruchs 1 derart auszugestalten, so daß die beiden aneinandergrenzenden, sich in ihren spektralen Empfindlichkeitsbereichen unterscheidenden Halbleiterschichtbereichen aus der Kombination einer Photodiode und einem Quantumwell-Intersubband-Photodetektor besteht. Durch die erfindungsgemäße Kombination einer Photodiode mit einer QWIP-Struktur ist es im Unterschied zu den bisherigen Ansätzen zur Realisierung elektrisch abstimmbarer Zweifarbendetektoren gelungen, daß das Rauschverhalten des erfindungsgemäßen Zweifarbendetektors durch das Rauschen des jeweils aktiven Einzeldetektors bestimmt wird.

Vorzugsweise werden die in ihrem Aufbau unterschiedlichen Einzeldetektoren derart auf einem Grundsubstrat aufgebracht, so daß mit den Mitteln epitaktischer Abscheideverfahren, vorzugsweise dem Molekularstrahlepitaxie-Verfahren, die Schichtenfolge einer p-i-n-Photodiode auf einem Grundsubstrat abgeschieden wird, über den in unmittelbarer Abfolge die Schichtenfolge eines Quantumwell-Intersubband-Photodetektor aufgebracht wird. Überdies werden wenigstens zwei Elektroden vorgesehen, von denen die eine mit dem der QWIP-Struktur gegenüberliegenden Kontaktschicht der Photodiode und die andere Elektrode mit der obersten Deckschicht der QWIP-Struktur kontaktiert wird.

Bei Anlegen einer äußeren elektrischen Spannung an die Elektroden derart, daß sich die p-i-n-Photodiode in Durchlaßrichtung befindet, ist die spektrale Empfindlichkeit des erfindungsgemäßen Zweifarbendetektors durch den Halbleitersschichtbereich der QWIP-Struktur vorgegeben. Der Grund hierfür liegt darin, daß die Photodiode, die in Durchlaßrichtung betrieben wird, einen vernachlässigbaren differentiellen Innenwiderstand aufweist, so daß sie die Empfindlichkeit der aktiven QWIP-Struktur nicht nachhaltig beeinflußt.

Wird hingegen die äußere Spannung derart angelegt, daß sich die Photodiode in Sperrichtung befindet, so bestimmt sich die Empfindlichkeit des gesamten Zweifarbendetektors einzig und allein durch die Photodiode. Dies liegt daran, daß die Photodiode einen extrem hohen Dunkelwiderstand aufweist, gegenüber dem der differentielle Innenwiderstand der QWIP-Struktur vernachlässigt werden kann.

### Kurze Beschreibung der Zeichnung

Die Erfindung wird nachstehend anhand eines Ausführungsbeispieles unter Bezugnahme auf die Zeichnung exemplarisch beschrieben. Es zeigen:
- Fig. 1a, b: Bänderdiagramm eines erfindungsgemäßen Zweifarbendetektors in zwei unterschiedlichen Betriebszuständen,
- Fig. 2: Abhängigkeitsdiagramm der Detektorempfindlichkeit im Verhältnis zur äußeren, angelegten Spannung.

### Darstellung von Ausführungsbeispielen

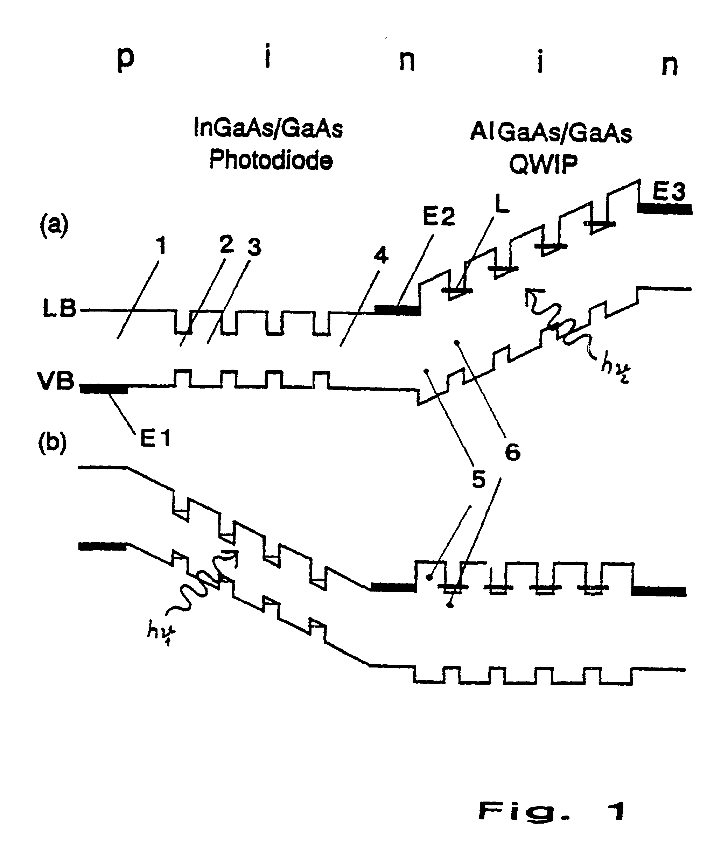

Aus Figur 1 sind in den Teilfiguren a und b jeweils die Bänderschema einer vorteilhaften Ausführungsform des erfindungsgemäßen Zweifarbendetektors dargestellt. Die *in* den Teilfiguren sich gegenüberliegenden Linienzüge entsprechen jeweils dem Valenz- (VB) und dem Leitungsband (LB).

Die Schichtabfolge ist dabei derart gewählt, daß beginnend mit dem linken Rand auf einer Grundsubstratschicht, die aus GaAs besteht eine p-dotierte GaAs-Schicht (1) aufgebracht ist, die zugleich den p-Bereich der p-i-n-Photodiode darstellt. Im übrigen sind alle weiteren Schichtenfolgen mit Hilfe der Molekularstrahlepitaxie aufeinander aufgebracht. Der für eine Photodiode charakteristische intrinsische (i) Bereich weist eine Vielzahl, dünner, alternierender InGaAs-Schichten (2) in Abfolge mit GaAs-Schichten (3) auf. Hierbei entsprechen die Schichten mit geringeren Bandabständen den Bereichen der InGaAs-Schichten, wohingegen die Schichtbereiche größerer Bandabstände GaAs enthalten. Die derart ausgebildete i-Schicht dient insbesondere der Erweiterung des Empfindlichkeitsbereiches zu Wellenlängen hin, für die das GaAs-Substrat transparent ist. Auf die in dem i-Bereich sogenannte abgetragene Multiquantumwell-Struktur ist eine n-dotierte GaAs-Schicht (4) abgeschieden. Sie stellt zugleich auch den n-Bereich der p-i-n-Photodiode dar. Unmittelbar auf die n-Schicht ist eine Quantumwell-Intersubband-Struktur aufgebracht, die Schichtabfolgen aus AlGaAs (5) und GaAs (6) aufweist. Bereiche mit größerem Bandabstand entsprechen den AlGaAs-Schichten, wohingegen die dazwischen liegenden Bereiche mit jeweils kleinerem Bandabstand aus n-dotierten GaAs bestehen. Als die Quantum-Intersubband-Struktur abschließende Deckschicht wird eine n-dotierte GaAs Schicht verwendet.

Die Quantumwell-Struktur ist dabei derart dimensioniert, daß die in den Potentialtöpfen befindlichen Ladungsträger L quantisierte Zustände einnehmen und daß die Barrierenhöhe, die durch den großen Bandabstand in den AlGaAs-Schichten bestimmt sind, ein Durchtunneln der Ladungsträger von einem zum anderen Potentialtopf ausschließen.

Die erfindungsgemäße Kombination aus einer Photodiode und einer QWIP-Struktur ist gemäß Ausführungsbeispiel der Figur 1 wie dort angegeben mit den Elektroden E1, E2 und E3 versehen. Die Elektrode E2, die vorzugsweise auf dem n-Bereich der Photodiode aufgebracht ist, ist als floatende Elektrode ausgeführt.

Über die Elektroden E1 und E2 wird eine äußere Spannung angelegt, die im Fall a) derart gewählt ist, daß sich die Photodiode in Durchlaßrichtung befindet. Unter diesen Spannungsverhältnissen wird das Bänderschema der QWIP-Struktur aufgrund des äußeren, bestehenden elektrischen Feldes derart verbogen, daß aufgrund optischer Anregung die in den unteren Intersubbändern befindlichen Elektronen in obere, nicht eingezeichnete Zustände angeregt werden, die in der Nähe bzw. oberhalb der Ladungsbandkante liegen. Durch optische Anregung können derartige Ladungsträger zum Teil auch ins Kontinuum, d.h. über die Leitungsbandkantenenergie, gehoben werden, so daß sie aufgrund des äußeren elektrischen Feldes sofort seitlich abgezogen werden und auf diese Weise zum Photostrom beitragen können.

Der Betriebszustand des Zweifarbendetektors gemäß Figur 1a stellt den Fall dar, in dem der spektrale Empfindlichkeitsbereich der QWIP-Struktur überwiegt, wodurch der sich bildende Photostrom einzig und allein aus Ladungsträgern zusammensetzt, die aufgrund von Intersubbandabsorptionsprozessen herrühren.

Wird hingegen die äußere Spannung derart angelegt, daß die Photodiode in Sperrichtung gepolt ist, so werden die innerhalb der i-Schicht der Photodiode generierten Ladungsträger aufgrund optischer Absorption durch das innerhalb der i-Schicht vorherrschende elektrische Feld aufgetrennt und tragen auf diese Weise zum Photostrom bei.

Ein wesentlicher Gesichtspunkt beim Betrieb des erfindungsgemäßen Zweifarbendetektors besteht darin, daß das Rauschverhalten des Gesamtdetektors jeweils von dem Teil des Detektors bestimmt ist, in dem der jeweilige Photostrom generiert wird. Dies liegt insbesondere darin, daß die in Sperrichtung gepolte Photodiode einen extrem hohen Dunkelwiderstand aufweist, gegenüber dem der differentielle Innenwiderstand der QWIP-Struktur vernachlässigt werden kann. Ebenso weist der differentielle Innenwiderstand der Photodiode, die in Durchlaßrichtung gepolt ist, einen derart kleinen Wert auf, so daß der Rauschanteil aus diesem Detektorbereich gegenüber dem Rauschanteil der aktiv betriebenen QWIP-Struktur durch geeignete Materialwahl vernachlässigt werden kann.

Vorzugsweise ist der Zweifarbendetektor, wie im angegebenen Beispiel gemäß Figur 1 derart auf zwei Wellenlängen zu optimieren, so daß längerwellige Strahlungsanteile von der QWIP-Struktur und kürzere Wellenlängenanteile von der p-i-n-Photodiode absorbiert werden.

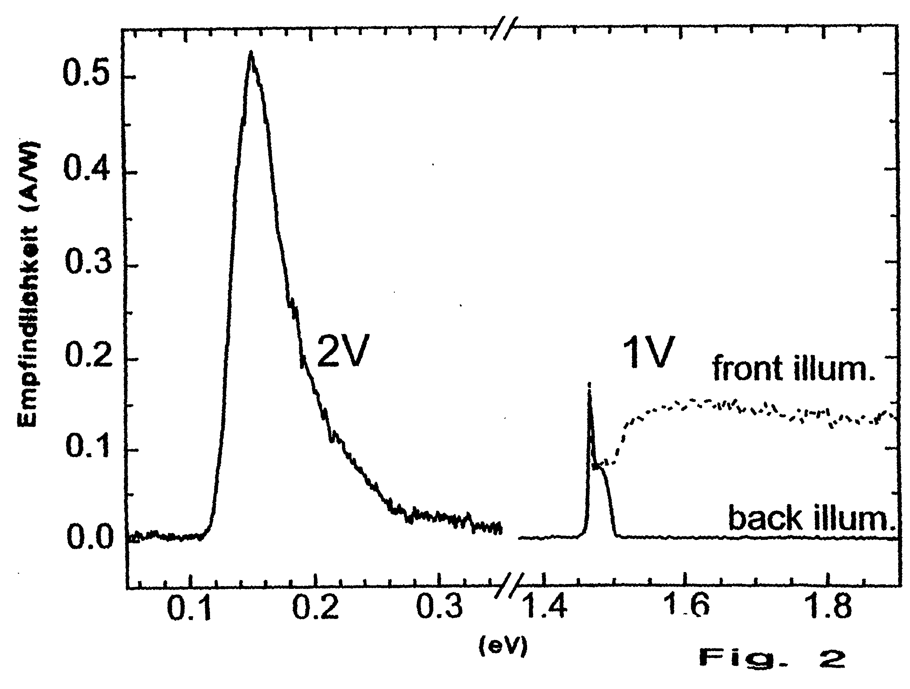

Aus Figur 2 geht ein Diagramm hervor, aus dem das spektrale Empfindlichkeitsverhalten in Abhängigkeit der Photonenenergie des in Figur 1 angegebenen Zweifarbendetektors bei zwei unterschiedlichen Spannungsverhältnissen dargestellt ist. Die spektrale Empfindlichkeit ist in Ampere pro eingestrahlte Photonen-Leistung in Watt entlang der Ordinate dargestellt. Die Photonenenergien sind an der Abszisse aufgetragen.

Bei einer äußeren Spannung von 2 Volt in Durchlaßrichtung bezüglich der Photodiode beträgt die spektrale Empfindlichkeit in der QWIP-Struktur 0,5 A/W bei einer Photonenenergie von 153 meV.

Wird hingegen eine Bias-Spannung von 1 Volt in Sperrichtung bezüglich der Photodiode eingestellt, so ergibt sich im Bereich der Photodiode eine spektrale Empfindlichkeit von 0,18 A/W bei einer Photonenenergie von 1,47 eV.

Die mit dem erfindungsgemäßen Zweifarbendetektor gewonnenen Meßdaten entsprechen jeweils den Detektorempfindlichkeiten von an sich bekannten Einzeldetektoren, so daß gezeigt werden kann, daß die Kombination eines Strahlungsdetektors bestehend aus einer Photodiode und einem Quantumwell-Intersubband-Photodetektors ähnliche Detektionseigenschaften aufweist, wie es bei Einzeldetektoren in Alleinstellung der Fall ist.

Ferner geht aus Figur 2 im rechten unteren Teil des Diagramms hervor, daß durch Bestrahlung des Zweifarbendetektors von der Rückseite (back illum.), d.h. von Seiten des Grundsubstrates, der Empfindlichkeitsbereich bei etwa 1,5 eV abbricht, was mit der große Absorption durch das Grundsubstrat erklärbar ist. Im Gegensatz hierzu ist gestrichelt die spektrale Empfindlichkeit der Photodiode in Vorwärtsbestrahlung dargestellt, die erheblich über der Funktion der Rückwärtsbestrahlung liegt.

Neben der oben erwähnten konkreten Ausführungsform des erfindungsgemäßen Zweifarbendetektors sind auch weitere Materialkombinationen bzw. Dotierungsmöglichkeiten denkbar. So können ebenso n-i-p-Photodioden verwendet werden und mit einer entsprechend p-dotierten Quantumwell-Struktur kombiniert werden. Ebenso sind invertierte Schichtreihenfolgen denkbar, bei denen zuerst die QWIP-Struktur und danach erst die Schichten der Photodiode auf dem Substrat abgeschieden werden. Zusätzliche Ausgestaltungen ergeben sich beispielsweise bei der Verwendung eines p-dotierten Quantumwell-Intersubband-Photodetektors, d.h. eine QWIP-Struktur mit p-dotierten Quantenwell-Schichten und einem p-leitenden Kontakt.

Desweiteren ergeben sich Alternativen zu dem oben beschriebenen Materialsystem AlGaAs/GaAs/InGaAs. So bietet es sich an auf einem InP-Substrat als QWIP-Struktur eine Vielfachschichtabfolge bestehend aus InGaAs/InAlAs an die Gitterkonstante des Substrat-Kristalls angepaßt bzw. leicht verspannt auf dem Grundsubstrat abzuscheiden. Ferner ist als Photodiodenmaterial InGaAs zu wählen.

Alternativ dazu kann auf einem GaSb-Substrat als QWIP-Struktur eine Vielfachschichtabfolge bestehend aus GaSb/AlGaSb abgeschieden werden, über das entweder als Photodiodenschicht InAs oder ein Übergitter bestehend aus GaSb-InAs oder bestehend AlGaSb/InGaSb abgeschieden werden kann.

Die durch Einsatz unterschiedlicher Materialien sowie geeignete Wahl von Schichtparametern und Dotierungstypen können Zweifarbendetektoren unter Verwendung der erfindungsgemäßen Kombination aus einer Photodiode und einer QWIP-Struktur beliebig konditioniert werden, so daß beide Detektorbereiche getrennt voneinander auf jeweils unterschiedliche spektrale Empfindlichkeitsbereiche optimiert werden können.

Als weitere vorteilhafte Weiterbildung des erfindungsgemäßen Halbleiterheterostruktur-Strahlungsdetektors wird ein üblicherweise in Verbindung mit QWIP-Detekoren verwendetes Beugungsgitter eingesetzt, das auf bzw. unter die Detektorstruktur aufgebracht wird. Die Vorteile eines derartigen Gitters rühren daher, daß aufgrund der Polarisationsauswahl-regeln für Intersubbandübergänge das einfallende Licht eine Komponente des elektrischen Feldvektors entlang der Wachstumrichtung des Halbleitergitters aufweisen muß. Dies bedeutet, daß die Ausbreitungsrichtung des Lichtes innerhalb der Detektorstruktur senkrecht bzw. schräg zur Wachstumsrichtung erfolgen soll. Um dieser Forderung besser nachkommen zu können, werden der auf die Struktur einfallende Strahlungsanteil bzw. der gegenüber der beleuchteten Seite des Detektors reflektierte Anteil der Strahlung, der im spektralen Empfindlichkeitsbereich des Quantumwell-Intersubband-Photodetektors liegt, schräg zur Einfallsrichtung abbeugt.

Die erfindungsgemäßen Zweifarbendetektoren können im Einzelbetrieb sowie auch in einer Arrayanordnung betrieben werden. Typische laterale Abmessungen eines Einzeldetektors betragen (10 -1000 µm)² bei typischen Gesamtschichtdicken von wenigen µm. Insbesondere finden derartige Zweifarbendetektoren Einsatz in sogenannten Focal-Plane-Array Kamerasystemen die beispielsweise zur Thermographie eingesetzt werden.

## Patentansprüche

1. Halbleiterheterostruktur-Strahlungsdetektor, der zwei aneinandergrenzende, in unterschiedlichen spektralen Bereichen empfindliche Halbleiterschichtbereiche aufweist, in denen Photonen mit jeweils unterschiedlichen Energien absorbierbar sind, die in den Halbleiterschichtbereichen vorhandene Ladungsträger derart optisch anregen, so dass ein Photostrom in den jeweiligen Halbleiterschichtbereichen in Abhängigkeit einer über Elektroden, die an der Halbleiterheterostruktur vorgesehen sind, anliegenden äußeren elektrischen Spannung generierbar ist,
**dadurch gekennzeichnet, dass** der Halbleiterheterostruktur-Strahlungsdedektor eine p-i-n-i-n Struktur oder eine n-i-p-i-p Struktur aufweist, der eine Halbleiterschichtbereich eine p-i-n Photodiode und der andere ein Quantumwell-Intersubband-Photodetektor ist.

2. Halbleiterheterostruktur-Strahlungsdetektor nach Anspruch 1,
**dadurch gekennzeichnet, dass** der Quantumwell-Intersubband-Photodetektor n-leitend ist und die Photodiode einen n-dotierten Bereich aufweist, der an den Quantumwell- Intersubband-Photodetektor angrenzt, und dass zum Anlegen einer äußeren Spannung eine Elektrode am p-dotierten Bereich der Photodiode und eine zweite Elektrode am Quantumwell-Intersubband-Photodetektor angebracht ist.

3. Halbleiterheterostruktur-Strahlungsdetektor nach dem Oberbegriff des Anspruchs 1,
**dadurch gekennzeichnet,**
**dass** der Quantumwell-Intersubband- Photodetektor p-leitend ist und die Photodiode einen p-dotierten Bereich aufweist, der an den Quantumwell-Intersubband-Photodetektor angrenzt, und dass zum Anlegen einer äußeren Spannung eine Elektrode am n-dotierten Bereich der Photodiode und eine zweite Elektrode am Quantumwell-Intersubband-Photodetektor angebracht ist.

4. Halbleiterheterostruktur-Strahlungsdetektor nach Anspruch 1,
**dadurch gekennzeichnet, dass** auf einem Grundsubstrat zunächst die Schichtenabfolge einer Photodiode angeordnet ist, auf der sich unmittelbar die Schichtenfolge eines Quantumwell-Intersubband-Photodetektors befindet.

5. Halbleiterheterostruktur-Strahlungsdetektor nach Anspruch 1,
**dadurch gekennzeichnet, dass** auf einem Grundsubstrat zunächst die Schichtenabfolge eines Quantumwell-Intersubband-Photodetektors angeordnet ist, auf der sich unmittelbar die Schichtenfolge einer Photodiode befindet.

6. Halbleiterheterostruktur-Strahlungsdetektor nach einem der Ansprüche 2 bis 5,
**dadurch gekennzeichnet, dass** durch Einstellung unterschiedlicher Werte der äußeren Spannung die spektralen Empfindlichkeitsbereiche beider Halbleiterschichtbereiche selektierbar sind.

7. Halbleiterheterostruktur-Strahlungsdetektor nach einem der Ansprüche 1 bis 6,
**dadurch gekennzeichnet, dass** eine weitere Elektrode am n-Bereich der p-i-n-Photodiode vorgesehen ist.

8. Halbleiterheterostruktur-Strahlungsdetektor nach Anspruch 8,
**dadurch gekennzeichnet, dass** die Photodiode aus folgenden Schichten zusammengesetzt ist:
p-Schicht: p-dotiertes GaAs
i-Schicht: InGaAs/GaAs abwechselnde Schichtenfolge
n-Schicht: n-dotiertes GaAs
und dass der unmittelbar auf die n-Schicht der Photodiode aufgebrachte Quantumwell-Intersubband-Photodetektor alternierende Schichten jeweils aus AlGaAs und GaAs aufweist.

9. Halbleiterheterostruktur-Strahlungsdetektor nach einem der Ansprüche 1 bis 8,
**dadurch gekennzeichnet, dass** die für die Photoabsorption beitragenden Intersubbandabstände innerhalb des Quantumwell-Intersubband Photodetektors kleiner sind als die entsprechenden Bandabstände der Photodiode.

10. Halbleiterheterostruktur-Strahlungsdetektor nach einem der Ansprüche 1 bis 9,
**dadurch gekennzeichnet, dass** die Photodiode durch Anlegen einer äußeren Spannung in Durchlassrichtung einen gegenüber dem Quantumwell-Intersubband-Photodetektor vernachlässigbaren differentiellen Innenwiderstand aufweist.

11. Halbleiterheterostruktur-Strahlungsdetektor nach einem der Ansprüche 1 bis 10,
**dadurch gekennzeichnet, dass** die Photodiode durch Anlegen einer äußeren Spannung in Sperrrichtung einen Dunkelwiderstand aufweist, gegenüber dem der differentielle Innenwiderstand des Quantumwell-Intersubband- Photodetektors vernachlässigbar ist.

12. Halbleiterheterostruktur-Strahlungsdetektor nach einem der Ansprüche 1 bis 11,
**dadurch gekennzeichnet, dass** die Photodiode einen kürzerwelligen und der Quantumwell-Intersubband- Photodetektor einen längerwelligen Empfindlichkeitsbereich aufweist.

13. Halbleiterheterostruktur-Strahlungsdetektor nach einem der Ansprüche 1 bis 12,
**dadurch gekennzeichnet, dass** die einzelnen Schichtabfolgen der Photodiode und des Quantumwell-Intersubband- Photodetektors nacheinander durch epitaktisches Aufbringen auf einem Substrat angeordnet sind.

14. Halbleiterheterostruktur-Strahlungsdetektor nach einem der Ansprüche 1 bis 13,
**dadurch gekennzeichnet, dass** die zwei Halbleiterschichtbereiche folgende spektralen Empfindlichkeitsbereiche aufweisen:
- sichtbarer Spektralbereich oder nahes IR und 3-5 µm oder 8-12 um oder
- 3-5 µm und 8-12 µm.

15. Halbleiterheterostruktur-Strahlungsdetektor nach einem der Ansprüche 1 bis 7 oder 9 bis 14,
**dadurch gekennzeichnet, dass** auf einem InP-Substrat als Photodiodematerial InGaAs verwendbar ist und der Quantumwell-Intersubband-Photodetektor alternierende Schichten jeweils aus InGaAs und InAlAs aufweist.

16. Halbleiterheterostruktur-Strahlungsdetektor nach einem der Ansprüche 1 bis 7 oder 9 bis 14,
**dadurch gekennzeichnet, dass** auf einem GaSb-Substrat als Photodiodematerial InAs oder GaSb/InAs-Übergitter oder AlGaSb/InGaSb-Übergitter verwendbar ist und
der Quantumwell-Intersubband-Photodetektor alternierende Schichten jeweils aus GaSb und AlGaSb aufweist.

17. Halbleiterheterostruktur-Strahlungsdetektor nach einem der Ansprüche 1 bis 16,
**dadurch gekennzeichnet, dass** ein Beugungsgitter auf bzw. unter dem Halbleiterheterostruktur-Strahlungs-detektor vorgesehen ist, das den auf die Struktur einfallenden Strahlungsanteil bzw. den gegenüber der beleuchteten Seite des Detektors reflektierten Anteil der Strahlung, der im spektralen Empfindlichkeitsbereich des Quantumwell-Intersubband-Photodetektors liegt, schräg zur Einfallsrichtung abbeugt.

## Claims

1. Semiconductor hetero structure radiation detector comprising two adjacent semiconductor layer regions sensitive in different spectral ranges in which photons of respective different energy levels can be absorbed, which optically excite charged particles present in the semiconductor layer regions in such a way that a photo current can be generated in the respective semiconductor layer regions as a function of an external electrical voltage applied via electrodes provided on the semiconductor hetero structure,
**characterised in that** the semiconductor hetero structure radiation detector presents a p-i-n-i-n or an n-i-p-i-p structure, that one semiconductor layer region is a p-i-n photo diode and that the other region is a quantum well inter sub-band photo detector.

2. Semiconductor hetero structure radiation detector according to Claim 1,
**characterised in that** the quantum well inter sub-band photo detector is of the n-type conducting type and that the photo diode presents an n-type doped region adjoining the quantum well inter sub-band photo detector,
and that an electrode is disposed on the p-type doped region of the photo diode and a second electrode is provided on the quantum well inter sub-band photo detector for application of an external voltage.

3. Semiconductor hetero structure radiation detector according to Claim 1,
**characterised in that** the quantum well inter sub-band photo detector is of the p-type conducting type and the photo diode presents an p-type doped region adjoining said quantum well inter sub-band photo detector,
and that an electrode is mounted on the n-type doped region of said photo diode and a second electrode is disposed on the quantum well inter sub-band photo detector for application of an external voltage.

4. Semiconductor hetero structure radiation detector according to Claim 1,
**characterised in that** first the succession of layers of a photo diode is disposed on a base substrate, on which the succession of layers of a quantum well inter sub-band photo detector is directly provided.

5. Semiconductor hetero structure radiation detector according to Claim 1,
**characterised in that** first the succession of layers of a quantum well inter sub-band photo detector is disposed first, on which the succession of layers of a photo diode is directly provided.

6. Semiconductor hetero structure radiation detector according to any of the Claims 2 to 5,
**characterised in that** by setting different values of the external voltage, the spectral sensitivity regions of both semiconductor layer regions can be selected.

7. Semiconductor hetero structure radiation detector according to any of the Claims 1 to 6,
**characterised in that** a further electrode is provided on the n-type zone of the p-i-n photo diode.

8. Semiconductor hetero structure radiation detector according to Claim 8,
**characterised in that** said photo diode is composed of the following layers:
p-type layer: p-type doped GaAs
i-layer: InGaAs/GaAs succession of alternating layers
n-type layer: n-type doped GaAs
and that the quantum well inter sub-band photo detector, which is applied directly on the n-type layer of the photo diode comprises alternating layers each consisting of AlGaAs and GaAs.

9. Semiconductor hetero structure radiation detector according to any of the Claims 1 to 8,
**characterised in that** the inter sub-band gaps contributing to the photo absorption within the quantum well inter sub-band photo detector are smaller than the corresponding band gaps of the photo diode.

10. Semiconductor hetero structure radiation detector according to any of the Claims 1 to 9,
**characterised in that** the photo diode presents a differential internal resistance negligible relative to the quantum well inter sub-bands photo detector in the conducting direction in response to the application of an external voltage.

11. Semiconductor hetero structure radiation detector according to any of the Claims 1 to 10,
**characterised in that** in response to the application of an external voltage in the conducting direction, said photo diode presents a dark resistance relative to which the differential internal resistance of the quantum well inter sub-band photo detector is negligible.

12. Semiconductor hetero structure radiation detector according to any of the Claims 1 to 11,
**characterised in that** said photo diode has a sensitivity region for shorter wave lengths while said quantum well inter sub-band photo detector has a region for longer wave lengths.

13. Semiconductor hetero structure radiation detector according to any of the Claims 1 to 12,
**characterised in that** the individual succession of layers of said photo diode and said quantum well inter sub-band photo detector are disposed one after the other by epitaxial application on a substrate.

14. Semiconductor hetero structure radiation detector according to any of the Claims 1 to 13,
**characterised in that** the two semiconductor layer regions present the following spectral sensitivity regions:
- spectral range in the visible range or in the vicinity of IR and 3-5 µm or 8-12 µm or
- 3-5 µm and 8-12 µm.

15. Semiconductor hetero structure radiation detector according to any of the Claims 1 to 7 or 9 to 14,
**characterised in that** InGaAs can be used as photo diode material on an InP substrate and that the quantum well inter sub-band photo detector presents alternating layers consisting each of InGaAs and InAlAs.

16. Semiconductor hetero structure radiation detector according to any of the Claims 1 to 7 or 9 to 14,
**characterised in that** InAs or a GaSb/InAs superimposed grid or an Al-GaSb/InGaSb superimposed grid can be used as photo diode material on a GaSb substrate, and that the quantum well inter sub-band photo detector presents alternating layers consisting each of GaSb and AlGaSb,

17. Semiconductor hetero structure radiation detector according to any of the Claims 1 to 16,
**characterised in that** a diffraction grid is provided on or under the semiconductor hetero structure radiation detector, which diffracts the radiation fraction incident on the structure or the radiation fraction reflected opposite to the illuminated side of the detector, which is within the spectral sensitivity region of the quantum well inter sub-band photo detector, in a direction oblique relative to the direction of incidence.

## Revendications

1. Détecteur de rayonnement à hétéro structure de semi-conducteur comprenant deux régions contiguës à couches semi-conductrices sensibles au-dedans de gammes spectrales différentes, dans lesquelles des photons aux niveaux d'énergie différents respectifs peuvent être absorbé, qui excitent, de façon optique, des porteurs de charge présents dans les régions à couches semi-conducteurs d'une telle manière qu'un courant photoélectrique peut être engendré dans les régions respectives à couches semi-conducteurs en fonction d'une tension électrique extérieure appliquée via des électrodes disposées sur la hétéro structure de semi-conducteur,
**caractérisé en ce que** le détecteur de rayonnement à hétéro structure de semi-conducteur présente une structure p-i-n-i-n ou une structure n-i-p-i-p, **en ce qu'**une région de la couche semi-conducteur est une photodiode p-i-n, pendant que l'autre région est un détecteur photoélectrique à puits quantiques à intersous-bandes.

2. Détecteur de rayonnement à hétéro structure de semi-conducteur selon la revendication 1,
**caractérisé en ce que** le détecteur photoélectrique à puits quantiques à intersous-bandes est du type de conduction en *n*, et **en ce que** la photodiode présente une région dopée en *n*, contiguës au détecteur photoélectrique à puits quantiques à intersous-bandes,
et **en ce qu'**une électrode est disposée sur la région dopée en p de la photodiode, pendant qu'une deuxième électrode est disposée sur le détecteur photoélectrique à puits quantiques à intersous-bandes pour l'application d'une tension extérieure.

3. Détecteur de rayonnement à hétéro structure de semi-conducteur selon la revendication 1,
**caractérisé en ce que** le détecteur photoélectrique à puits quantiques à intersous-bandes est du type de conduction *p*, et que la photodiode présente une région dopée en *p*, contiguë ledit détecteur photoélectrique à puits quantiques à intersous-bandes,
et **en ce qu'**une électrode est montée sur la région dopée en *p* de ladite photodiode, pendant qu'une deuxième électrode est disposée sur le détecteur photoélectrique à puits quantiques à intersous-bandes pour l'application d'une tension extérieure.

4. Détecteur de rayonnement à hétéro structure de semi-conducteur selon la revendication 1,
**caractérisé en ce que** d'abord, la série de couches alternées d'une photodiode est disposée sur un substrat de base, sur lequel la série de couches alternées d'un détecteur photoélectrique à puits quantiques à intersous-bandes est appliquée directement.

5. Détecteur de rayonnement à hétéro structure de semi-conducteur selon la revendication 1,
**caractérisé en ce que** d'abord la série de couches alternées d'un détecteur photoélectrique à puits quantiques à intersous-bandes est disposée, sur laquelle on applique directement la série de couches alternées d'une photodiode.

6. Détecteur de rayonnement à hétéro structure de semi-conducteur selon une quelconque des revendications 2 à 5,
**caractérisé en ce que** le choix des zones de sensibilité spectrale des deux régions à couches semi-conductrices est possible par ajustage des valeurs différentes de la tension extérieure.

7. Détecteur de rayonnement à hétéro structure de semi-conducteur selon une quelconque des revendications 1 à 6,
**caractérisé en ce qu'**une électrode supplémentaire est appliquée sur la zone type *n* de la photodiode p-i-n.

8. Détecteur de rayonnement à hétéro structure de semi-conducteur selon la revendication 8,
**caractérisé en ce que** ladite photodiode est composée des couches suivantes:
couche *p*: GaAs dopé en *p*
couche *i*: série de couches alternées en InGaAs/GaAs
couche *n*: GaAs dopé en *n*
et **en ce que** le détecteur photoélectrique à puits quantiques à intersous-bandes, qui est appliqué directement sur la couche n de la photodiode, comprend des couches alternées, dont chacune consiste en AIGaAs et GaAs.

9. Détecteur de rayonnement à hétéro structure de semi-conducteur selon une quelconque des revendications 1 à 8,
**caractérisé en ce que** les intersous-gaps de bande, qui contribuent à l'absorption photoélectrique à l'intérieur du détecteur photoélectrique à puits quantiques à intersous-bandes, sont plus petits que les gaps de bande correspondants de la photodiode.

10. Détecteur de rayonnement à hétéro structure de semi-conducteur selon une quelconque des revendications 1 à 9,
**caractérisé en ce que** la photodiode présente une résistance interne différentielle négligeable, relativement au détecteur photoélectrique à puits quantiques à intersous-bandes, en sens de conduction en réponse à l'application d'une tension extérieure.

11. Détecteur de rayonnement à hétéro structure de semi-conducteur selon une quelconque des revendications 1 à 10,
**caractérisé en ce que**, en réponse à l'application d'une tension extérieure en sens de conduction, ladite photodiode présente une résistance d'obscurité, relativement à laquelle la résistance interne différentielle du détecteur photoélectrique à puits quantiques à intersous-bandes est négligeable.

12. Détecteur de rayonnement à hétéro structure de semi-conducteur selon une quelconque des revendications 1 à 11,
**caractérisé en ce que** ladite photodiode a une région sensible pour plus courtes longueurs d'onde, pendant que le détecteur photoélectrique à puits quantiques à intersous-bandes a une région sensible pour plus grandes longueurs d'onde.

13. Détecteur de rayonnement à hétéro structure de semi-conducteur selon une quelconque des revendications 1 à 12,
**caractérisé en ce que** les séries individuelles de couches alternées de ladite photodiode et ledit détecteur photoélectrique à puits quantiques à intersous-bandes sont disposées l'une après l'autre par dépôt à l'épitaxie sur un substrat.

14. Détecteur de rayonnement à hétéro structure de semi-conducteur selon une quelconque des revendications 1 à 13,
**caractérisé en ce que** les deux régions à couches semi-conductrices présentent les zones suivantes de sensibilité spectrale:
- gamme spectrale de visibilité à l'oeil ou gamme proche à l'infrarouge et 3-5 µm ou 8-12 µm ou
- 3-5 µm et 8-12 µm.

15. Détecteur de rayonnement à hétéro structure de semi-conducteur selon une quelconque des revendications 1 à 7 ou 9 à 14,
**caractérisé en ce que** l'emploi du InGaAs comme matériau de la photodiode sur un substrat en InP est possible, pendant que le détecteur photoélectrique à puits quantiques à intersous-bandes présente des couches alternées, dont chacune consiste en InGaAs et InAlAs.

16. Détecteur de rayonnement à hétéro structure de semi-conducteur selon une quelconque des revendications 1 à 7 ou 9 à 14,
**caractérisé en ce que** l'emploi du InAs ou une grille superposée en GaSb/InAs ou une grille superposée en AlGaSb/InGaSb comme matériau de la photodiode sur un substrat en GaSb est possible, et **en ce que** le détecteur photoélectrique à puits quantiques à intersous-bandes présente des couches alternées, dont chacune consiste en GaSb et AlGaSb.

17. Détecteur de rayonnement à hétéro structure de semi-conducteur selon une quelconque des revendications 1 à 16,
**caractérisé en ce qu'**une grille de diffraction est appliquée sur ou sous le détecteur de rayonnement à hétéro structure de semi-conducteur, qui diffracte la fraction de rayonnement, qui est incidente sur la structure, ou la fraction de rayonnement, qui est réfléchie vis-à-vis le côté illuminé du détecteur, qui se trouve au-dedans de la zone de sensibilité spectrale du détecteur photoélectrique à puits quantiques à intersous-bandes, en un sens oblique relativement à la direction d'incidence.
